# EUROPEAN PATENT APPLICATION

(11) **EP 4 306 484 A1**
(43) Date of publication of application: **17.01.2024**
(21) Application number: 22766830.8
(22) Date of filing: 14.02.2022
(51) Int. Cl.: C01B 32/28, B82Y 30/00, B82Y 40/00, C01B 32/26, H01L 29/06, H01L 35/14, H01L 35/24, H01L 35/34

(54) **PARTICLE IMMOBILIZING SUBSTRATE, METHOD FOR PRODUCING PARTICLE IMMOBILIZING SUBSTRATE, METHOD FOR PRODUCING DIAMOND FILM IMMOBILIZING SUBSTRATE, AND METHOD FOR PRODUCING DIAMOND**

(30) Priority: 10.03.2021 JP 2021038087; 18.10.2021 JP 2021170513
(71) Applicant: Daicel Corporation, Osaka 530-0011 (JP)
(72) Inventor: YOSHIKAWA, Taro, Tokyo 108-8230 (JP); LIU, Ming, Tokyo 108-8230 (JP); KOJIMA, Ryouta, Tokyo 108-8230 (JP); IEKI, Ryosuke, Tokyo 108-8230 (JP); MIYAKE, Hiroto, Tokyo 108-8230 (JP)
(74) Representative: Grünecker Patent- und Rechtsanwälte PartG mbB
(86) International application number: PCT/JP2022/007438
(87) International publication number: WO 2022/190869

(57) **Abstract**

Provided is a particle-immobilized substrate (1) that can be easily produced and has inorganic nanoparticles (3) present in a nanometer-scale region. Also provided is a method for easily producing a substrate (2) in which nanoparticles are arranged in a nanometer-scale region on a solid surface. A particle-immobilized substrate (1) includes a substrate (2) and a plurality of inorganic nanoparticles (3) disposed on the substrate (2), in which the plurality of inorganic nanoparticles (3) is disposed in contact with each other in a region having a width (D1) of 1 µm or less on the substrate (2).

## Description

### Technical Field

The present disclosure relates to a particle-immobilized substrate, a method for producing a particle-immobilized substrate, a method for producing a diamond-film-immobilized substrate, and a method for producing diamond. More specifically, the present disclosure relates to a particle-immobilized substrate in which inorganic nanoparticles are immobilized in a nanometer-scale region on a substrate, a method for producing the particle-immobilized substrate, a method for producing a diamond-film-immobilized substrate using the particle-immobilized substrate, and a method for producing diamond using the diamond-film-immobilized substrate. The present application claims priority from the Japanese patent application No. 2021-038087 filed in Japan on March 10, 2021 and the Japanese patent application No. 2021-170513 filed in Japan on October 18, 2021, the contents of which are herein incorporated by reference.

### Background Art

Inorganic nanoparticles, such as nanodiamond and metal nanoparticles, may be used by selectively attaching a dispersion of the nanoparticles to an intended region on a solid substrate surface by inkjet printing or the like. For example, metal nanoparticles such as silver nanoparticles may be fired even at low temperatures. This property allows metal nanoparticles to be used for forming electrodes and conductive circuit patterns on a substrate in the production of various electronic devices. Inorganic nanoparticles have also been studied for use in nanodevices, in which the inorganic nanoparticles are arranged on the surface of a substrate. Substrates having inorganic nanoparticles arranged on their surfaces are expected to be applied to nanodevices in the semiconductor field, such as thermoelectric conversion devices, solar cells, displays, memories, thin-film transistors, and LSIs.

A known substrate with inorganic nanoparticles arranged on its surface includes one on which inorganic nanoparticles are attached and deposited in an intended region of a micrometer scale. However, in recent years, a technique for attaching inorganic nanoparticles to a nanometer-scale region on a surface of a solid substrate tends to be required.

Patent Document 1 discloses a method for arranging nanoparticles by applying a nanoparticle solution containing nanoparticles to which polymer chains are bonded onto a substrate and removing the solvent to arrange the nanoparticles, then removing the polymer chains from the nanoparticles to which the polymer chains are bonded on the substrate. According to this method, on the substrate on which the nanoparticles from which the polymer chains have been removed are arranged, voids derived from the polymer chains before removal are present between the nanoparticles, and the nanoparticles are individually scattered at equal intervals.

### Citation List

### Patent Documents

Patent Document 1: JP 2015-103609 A

### Summary of Invention

### Technical Problem

However, in the method of Patent Document 1, nanoparticles to which polymer chains are bonded are arrayed. In this way, it is necessary to first prepare nanoparticles to which polymer chain are bonded like in the method of Patent Document 1 in order to arrange nanoparticles to which polymer chains are not bonded. Thus, it becomes complicated to produce a substrate in which nanoparticles are arranged in a nanometer-scale region on a solid surface.

An object of the present disclosure is to provide a particle-immobilized substrate that can be easily produced and has inorganic nanoparticles present in a nanometer-scale region. Another object of the present disclosure is to provide a method capable of easily producing a substrate in which nanoparticles are arranged in a nanometer-scale region on a solid surface. Another object of the present disclosure is to provide a method capable of easily producing a substrate in which a diamond film is immobilized on a solid surface, preferably in a nanometer-scale region.

### Solution to Problem

The present disclosure provides a particle-immobilized substrate including a substrate and a plurality of inorganic nanoparticles disposed on the substrate, the plurality of inorganic nanoparticles being disposed in contact with each other in a region having a width of 1 µm or less on the substrate.

The present disclosure also provides a particle-immobilized substrate including a substrate and inorganic nanoparticles disposed on the substrate,
in which a potential difference between a zeta potential of the inorganic nanoparticles and a zeta potential of a surface of the substrate at a position where the inorganic nanoparticles are disposed is 30 mV or more.

It is preferable that a plurality of the regions having a width of 1 µm or less is regularly arranged on the substrate, and the inorganic nanoparticles are disposed in each of the plurality of the regions having a width of 1 µm or less.

It is preferable that the nanoparticles include nanodiamond particles.

The present disclosure also provides a method for producing a particle-immobilized substrate including disposing, on a substrate including a first region and a second region with a potential difference of each other between a zeta potential of the first region and a zeta potential of the second region of 30 mV or more, inorganic nanoparticles by electrostatic action in a region having a width of 1 µm or less that is present in the first region.

It is preferable that a zeta potential of either the first region or the second region is positive, a zeta potential of the other is negative.

The present disclosure also provides a method for producing a particle-immobilized substrate, the method including disposing, on a substrate including a first region and a second region in which a zeta potential of either the first region or the second region is positive and a zeta potential of the other is negative, inorganic nanoparticles by electrostatic action in a region having a width of 1 µm or less that is present in the first region.

It is preferable that a plurality of the first regions is regularly arranged on the substrate, and the inorganic nanoparticles are disposed in each of the plurality of the first regions.

It is preferable that the inorganic nanoparticles include nanodiamond particles.

The present disclosure also proposes a method for producing a diamond-film-immobilized substrate, the method including a CVD step of forming a diamond film on the particle-immobilized substrate by growing the nanodiamond particles on the substrate by a chemical vapor deposition method using the nanodiamond particles as seeds.

It is preferable that in the CVD step, the diamond film is formed in a region having a width of 1 µm or less on the substrate.

The present disclosure also provides a method for producing diamond including removing the substrate from the diamond-film-immobilized substrate to obtain an independent self-standing solid of the diamond film or diamond particles constituting the diamond film.

### Advantageous Effects of Invention

According to the particle-immobilized substrate of the present disclosure, it is possible to provide a particle-immobilized substrate that can be easily produced and has inorganic nanoparticles present in a nanometer-scale region. According to the method for producing a particle-immobilized substrate according to the present disclosure, the particle-immobilized substrate can be easily produced. According to the method for producing a diamond-film-immobilized substrate according to the present disclosure, a substrate in which a diamond film is formed on the substrate (in particular, in a nanometer-scale region of the substrate) can be easily produced.

### Brief Description of Drawings

FIG. 1 is an enlarged schematic view of a particle-immobilized substrate according to an embodiment of the present disclosure.
FIG. 2 is an enlarged schematic view of a particle-immobilized substrate according to another embodiment of the present disclosure.
FIG. 3 is a schematic view illustrating an embodiment of a method for producing a substrate having regions different in zeta potential from each other.
FIG. 4 is a schematic view illustrating another embodiment of the method for producing a substrate having regions different in zeta potential from each other.
FIG. 5 is an enlarged schematic view of a diamond-film-immobilized substrate according to an embodiment of the present disclosure.
FIG. 6 is an enlarged schematic view of a diamond film according to another embodiment of the present disclosure.
FIG. 7 is a micrograph of a particle-immobilized substrate produced in Example 1.
FIG. 8 is a micrograph of a particle-immobilized substrate produced in Example 2.

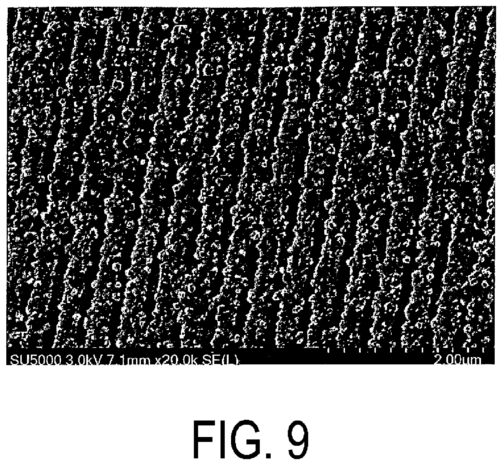

FIG. 9 is a micrograph of the diamond-film-immobilized substrate of No. 1 produced in Example 3.

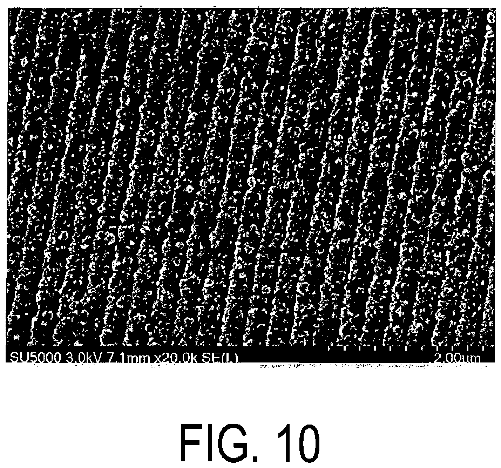

FIG. 10 is a micrograph of the diamond-film-immobilized substrate of No. 2 produced in Example 3.

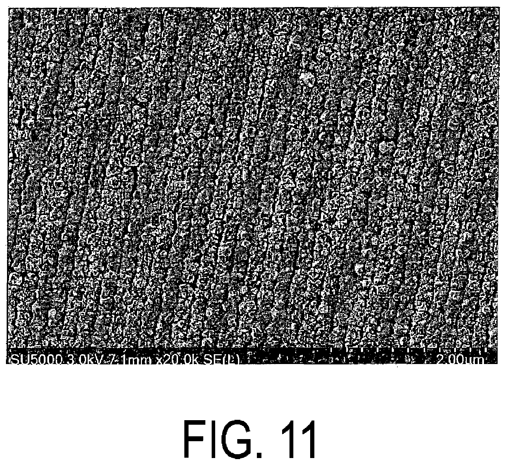

FIG. 11 is a micrograph of the diamond-film-immobilized substrate of No. 3 produced in Example 3.

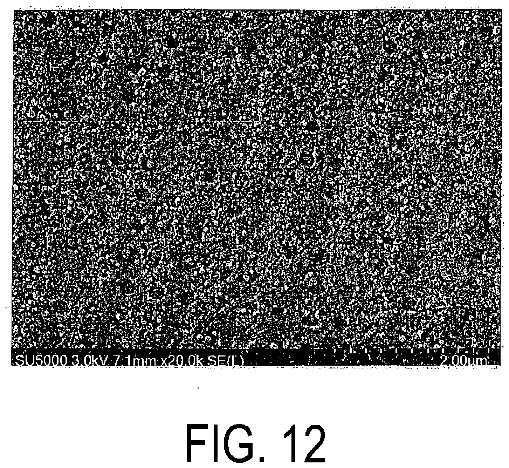

FIG. 12 is a micrograph of the diamond-film-immobilized substrate of No. 4 produced in Example 3.
FIG. 13 is an atomic force microscope (AFM) image of a portion where the surface roughness of the surface of the diamond film of No. 1 was measured.
FIG. 14 is an atomic force microscope (AFM) image of a portion where the height plot of the diamond film of No. 1 is measured and the measurement results.

### Description of Embodiments

### Particle-Immobilized Substrate

A particle-immobilized substrate according to an embodiment of the present disclosure includes at least a substrate and inorganic nanoparticles disposed on the substrate. The inorganic nanoparticles are disposed in a region having a width of 1 µm or less on the substrate. In the particle-immobilized substrate according to an embodiment of the present disclosure, a plurality of inorganic nanoparticles is disposed in contact with each other in a region having a width of 1 µm or less on the substrate. In a particle-immobilized substrate according to another embodiment of the present disclosure, a potential difference between a zeta potential of the inorganic nanoparticles and a zeta potential of the substrate at a position where the inorganic nanoparticles are disposed is 30 mV or more. In the present specification, the region having a width of 1 µm or less where the inorganic nanoparticles are disposed may be referred to as "particle-disposed nanoregion".

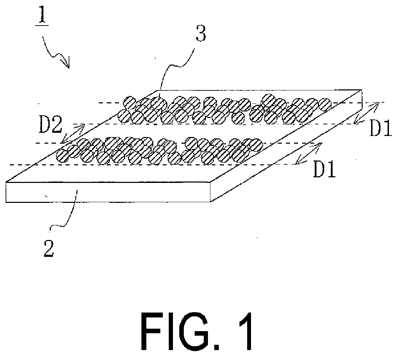

FIG. 1 is an enlarged schematic view of an embodiment of the particle-immobilized substrate. The particle-immobilized substrate 1 includes a substrate 2 and a plurality of inorganic nanoparticles 3. In the particle-immobilized substrate 1, the plurality of inorganic nanoparticles 3 is disposed on the substrate 2 in a region (particle-disposed nanoregion) having a width D1 of 1 µm or less and extending in a lateral direction (a direction orthogonal to the width D1), and a single layer composed only of the inorganic nanoparticles 3 is formed in the particle-disposed nanoregion. Some of the inorganic nanoparticles 3 are in contact with each other. The potential difference between the zeta potential of the inorganic nanoparticles 3 and the zeta potential of the substrate 2 at the position where the inorganic nanoparticles 3 are disposed is 30mV or more. A plurality of regions where the width D1 extends in the lateral direction is arranged at intervals of D2 in a longitudinal direction to form a stripe pattern.

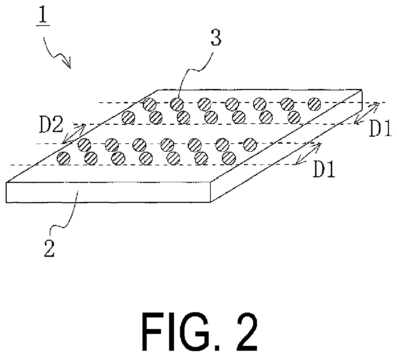

FIG. 2 is an enlarged schematic view of another embodiment of the particle-immobilized substrate. The particle-immobilized substrate 1 includes a substrate 2 and a plurality of inorganic nanoparticles 3. The difference from the particle-immobilized substrate 1 in FIG. 1 is that the plurality of inorganic nanoparticles 3 is not in contact with each other and they are regularly disposed.

The length of the particle-disposed nanoregion is 1 µm or less. The length may be 600 nm or less, 300 nm or less, or 150 nm or less.

Specific examples of the shape of the particle-disposed nanoregion include a rectangle as illustrated in FIG. 1, other polygons, a perfect circle, an ellipse, a wavy line, an oblique line (parallelogram), and an indefinite shape. For a rectangle, an ellipse, a wavy line, and an oblique line, it is obvious which length corresponds to the "width" described above. For other shapes extending in one direction and having a long axis and a short axis, the short axis corresponds to the "width" described above. In a shape in which there is no distinction between a long axis and a short axis, such as a regular polygon or a perfect circle, the longest diameter of the shape corresponds to the "width". In a shape having a variable width, the minimum width of the shape may be the "width".

Only one particle-disposed nanoregion may be present on the substrate, or a plurality of particle-disposed nanoregions may be present in the same or different shapes. The particle-disposed nanoregions may be regularly disposed (arranged) or may be irregularly disposed, but it is preferable that they are regularly disposed. Examples of the pattern formed by the regular disposition include a stripe pattern, a dot pattern, a check pattern, a lattice pattern, a houndstooth pattern, and a mesh pattern. The shape of the dots in the dot pattern is not limited to particular shapes, and examples thereof include a cross shape, a circle, and a polygon.

The interval (for example, D2 in FIG. 1) between the plurality of particle disposition regions in the regularly arranged shape such as the stripe pattern or the dot pattern is not limited to particular values, but it is preferably from 0.1 to 1.5 times, more preferably from 0.5 to 1.0 times the width.

The inorganic nanoparticles are disposed in a region (particle-disposed nanoregion) having a width of 1 µm or less on the substrate. When a plurality of inorganic nanoparticles is disposed in the particle-disposed nanoregion, some or all of the plurality of inorganic nanoparticles may be in contact with each other in the region having a width of 1 µm or less on the substrate. In this case, two inorganic nanoparticles in contact with the substrate may be in contact with each other.

In the particle-immobilized substrate, the plurality of inorganic nanoparticles may form a single layer of the particles (a layer composed only of the inorganic nanoparticles without containing other components such as a resin component). The single layer may be a layer in which the inorganic nanoparticles are not stacked in a height direction (inorganic nanoparticle single layer) or a layer in which the inorganic nanoparticles are stacked in the height direction (inorganic nanoparticle multiple layer). When there is a plurality of the particle-disposed nanoregions, the inorganic nanoparticle single layer and the inorganic nanoparticle multiple layer may be mixed in the plurality of regions.

The presence of the inorganic nanoparticles in a region having a width of 1 µm or less and the contact of the plurality of inorganic nanoparticles with each other in the particle-disposed nanoregion may be confirmed by observing the particle-immobilized substrate with an atomic force microscope (AFM). The width of the particle-disposed nanoregion and the interval between the plurality of particle-disposed nanoregions may also be measured by the AFM.

The particle-immobilized substrate includes a region where the inorganic nanoparticles are not disposed other than the particle-disposed nanoregion. The particle-immobilized substrate may have a region where inorganic nanoparticles are immobilized in a region other than the particle-disposed nanoregion (that is, a region having a width of more than 1 µm).

The potential difference between the zeta potential of the inorganic nanoparticles and the zeta potential of the substrate at the position where the inorganic nanoparticles are disposed is preferably 30 mV or more, more preferably 40 mV or more, and still more preferably 50 mV or more. When the potential difference is 30 mV or more, the potential difference between the inorganic nanoparticles and the substrate surface at the position where the inorganic nanoparticles are disposed is sufficiently large, with which the inorganic nanoparticles and the substrate can be easily attached to each other with electrostatic action, and the inorganic nanoparticles are hardly detached after the attachment. The potential difference of at least one point from pH 2 to 12 (preferably from pH 4 to 10, more preferably from pH 5 to 8) is preferably within the above ranges.

Examples of the inorganic nanoparticles include metal nanoparticles, semiconductor nanoparticles, and nanocarbon particles. The inorganic nanoparticles may include one kind or two or more kinds thereof.

Examples of the material constituting the metal nanoparticles and the semiconductor nanoparticles include silver, aluminum, gold, platinum, palladium, copper, cobalt, chromium, indium, nickel, and gallium. Of these, silver is preferred. Only one of the materials may be used, or two or more may also be used. Specific examples of the metal nanoparticles and the semiconductor nanoparticles include nanoparticles made of one type or a mixture of two or more types of the above materials, and nanoparticles made of a compound of the above materials (for example, GaN nanoparticles, GaAs nanoparticles, AIN nanoparticles, and GaAIN nanoparticles).

The nanocarbon particles described above are not particularly limited, and particles of a known or commonly used nano-order carbon material (nanocarbon material) can be used. Examples of the nanocarbon material of the nanocarbon particles include nanodiamonds, fullerenes, graphene oxide, nanographite, carbon nanotubes, carbon nanofilaments, onion-like carbon, diamond-like carbon, amorphous carbon, carbon black, carbon nanohorns, and carbon nanocoils. Among these, nanodiamond particles are preferable as the nano carbon particles.

As used herein, the term "inorganic nanoparticles" means inorganic particles having a primary particle size (average primary particle size) of less than 1000 nm. The average primary particle size of the inorganic nanoparticles is, for example, 100 nm or less, preferably 60 nm or less, more preferably 50 nm or less, and still more preferably 30 nm or less. The lower limit of the average primary particle size of the inorganic nanoparticles is, for example, 1 nm.

As the nanodiamond particles, for example, a detonation nanodiamond (that is, nanodiamond produced by a detonation method) or a high-temperature high-pressure nanodiamond (that is, nanodiamond produced by a high-temperature high-pressure method) may be used. Of these, a detonation nanodiamond is preferred in that dispersibility in a dispersion medium is even better, that is, in that primary particles have a particle size of a single-digit nanometer.

Examples of the detonation nanodiamond include an air-cooled detonation nanodiamond (that is, nanodiamond produced by an air-cooled detonation method) and a water-cooled detonation nanodiamond (that is, nanodiamond produced by a water-cooled detonation method). Of these, an air-cooled detonation nanodiamond is preferred in that primary particles are smaller than those of a water-cooled detonation nanodiamond.

The nanodiamond particles are not limited, and publicly known or commonly used nanodiamond particles may be used. The nanodiamond particles may be nanodiamond particles whose surfaces are modified (surface-modified nanodiamond particles) or may be nanodiamond particles whose surfaces are not modified. Nanodiamond particles whose surfaces are not modified have hydroxy groups (-OH) or carboxy groups (-COOH) on the surfaces. As the nanodiamond particles, only one type may be used, or two or more types may be used.

Examples of the compound or functional group modifying the surfaces of the nanodiamond particles in the surface-modified nanodiamond include a silane compound, a phosphonate ion or a phosphonate residue, a surface-modifying group having a vinyl group at a terminal, an amide group, a cation of a cationic surfactant, a group containing a polyglycerin chain, and a group containing a polyethylene glycol chain.

The zeta potential of the inorganic nanoparticles may be negative or positive. It is preferable that the zeta potential of the inorganic nanoparticles has the same sign as the zeta potential on the substrate where the inorganic nanoparticles are not disposed. When the zeta potential of the inorganic nanoparticles is positive, the zeta potential is preferably 5 mV or more, more preferably 10 mV or more, and still more preferably 20 mV or more. When the zeta potential of the inorganic nanoparticles is negative, the zeta potential is preferably -5 mV or less, more preferably -10 mV or less, and still more preferably -15 mV or less. Particles having many hydroxy groups or carboxy groups on the surfaces, such as nanodiamond particles whose surfaces are not modified, tend to have a negative zeta potential derived from oxygen-based functional groups. Examples of the nanodiamond particles having a positive zeta potential include nanodiamond particles whose surfaces are terminated with hydrogen. The zeta potential of at least one point from pH 2 to 12 (preferably from pH 4 to 10, more preferably from pH 5 to 8) is preferably within the above ranges.

Examples of the material constituting the substrate include, but are not limited to, resins, metals, metal oxides, metal carbides, metal nitrides, and glass. Examples of the resin include a polyolefin resin, a polyester resin, a polyamide resin, a polyimide resin, a polycarbonate resin, a phenol resin, an epoxy resin, a silicone resin, a fluororesin, and a urethane resin. Examples of the metal include Si, Au, Cu, Pt, Zn, Fe, Ta, Bi, Te, Ga, and an alloy containing at least one of these metals. Examples of the metal oxide include oxides of these metals. Of these, the substrate is preferably a Si substrate, a SiO₂ substrate, a SiC substrate, or a GaN substrate from the viewpoint that the particle-immobilized substrate can be applied to semiconductor applications.

The zeta potential of the surface of the region of the substrate on which the inorganic nanoparticles are disposed may be negative or positive. It is preferable that the zeta potential has a sign different from the sign of the zeta potential of the inorganic nanoparticles.

The zeta potential of the surface of the region of the substrate where the inorganic nanoparticles are not disposed may be negative or positive. It is preferable that the zeta potential of the surface of the region of the substrate where the inorganic nanoparticles are not disposed has the same sign as the zeta potential of the inorganic nanoparticles.

For the region where the inorganic nanoparticles are disposed and the region where the inorganic nanoparticles are not disposed in the substrate, the zeta potential of the surface when it is positive is preferably 5 mV or more, and more preferably 10 mV or more. For the region where the inorganic nanoparticles are disposed and the region where the inorganic nanoparticles are not disposed in the substrate, the zeta potential of the surface when it is negative is preferably -10 mV or less, and more preferably -20 mV or less. The zeta potential is a value measured under the same conditions as the conditions (for example, pH) for measuring the zeta potential of the inorganic nanoparticles.

The potential difference between the zeta potential of the inorganic nanoparticles and the zeta potential of the surface of the region of the substrate where the inorganic nanoparticles are disposed is preferably 30 mV or more, more preferably 40 mV or more, still more preferably 50 mV or more, and particularly preferably 60 mV or more. When the potential difference is 30 mV or more, the potential difference between the inorganic nanoparticles and the region is sufficiently large, and the inorganic nanoparticles can be easily and selectively disposed in a specific region with electrostatic action by appropriately setting the zeta potential of the inorganic nanoparticles. In addition, the inorganic nanoparticles are hardly detached after the attachment. The potential difference of at least one point from pH 2 to 12 (preferably from pH 4 to 10, more preferably from pH 5 to 8) is preferably within the above ranges.

The potential difference between the zeta potential of the surface of the region of the substrate where the inorganic nanoparticles are disposed and the zeta potential of the surface of the region where the inorganic nanoparticles are not disposed is preferably 30 mV or more, more preferably 40 mV or more, still more preferably 50 mV or more, and particularly preferably 60 mV or more. When the potential difference is 30 mV or more, the potential difference between the two regions is sufficiently large, and the inorganic nanoparticles can be easily and selectively disposed in a specific region with electrostatic action by appropriately setting the zeta potential of the inorganic nanoparticles. In addition, the inorganic nanoparticles are hardly detached after the attachment. The potential difference of at least one point from pH 2 to 12 (preferably from pH 4 to 10, more preferably from pH 5 to 8) is preferably within the above ranges.

The potential difference between the zeta potential of the inorganic nanoparticles and the zeta potential of the surface of the region of the substrate where the inorganic nanoparticles are not disposed is preferably less than 30 mV, more preferably 25 mV or less, and still more preferably 20 mV or less. When the potential difference between the zeta potentials is less than the 30 mV, the potential difference is small, with which the inorganic nanoparticles and the region of the substrate where the inorganic nanoparticles are not disposed repel each other, and thus the inorganic nanoparticles in the particle-disposed nanoregion are less likely to attach to the outside of the particle-disposed nanoregion. The zeta potential of at least one point from pH 2 to 12 (preferably from pH 4 to 10, more preferably from pH 5 to 8) is preferably within the above ranges.

The substrate preferably has a hydroxy group or a carboxy group (more preferably, a hydroxy group) on the surface of the region where the inorganic nanoparticles are not disposed. Substrates made of the above-described metal oxides tend to have a hydroxy group on their surfaces.

In the particle-immobilized substrate, inorganic nanoparticles are arranged in a very small region having a width of 1 µm. Thus, the particle-immobilized substrate may be preferably applied to nanodevices in the semiconductor field, such as thermoelectric conversion devices, solar cells, displays, memories, thin-film transistors, and LSIs. The particle-immobilized substrate may be preferably applied as a semiconductor device (nanodevice) using a core made of an inorganic nanoparticle as a quantum dot.

### Method for Producing Particle-Immobilized Substrate

The particle-immobilized substrate may be produced through a step of disposing inorganic nanoparticles in a first region on a substrate including the first region and a second region having zeta potentials different from each other with electrostatic action (electrostatic attachment step). Since electrostatic action of the surface of the inorganic substance constituting the inorganic nanoparticle is utilized in the electrostatic attachment step, the inorganic nanoparticle to be disposed in the electrostatic attachment step is a particle in which the inorganic substance constituting the inorganic nanoparticle is exposed on the surface, for example, a particle in which the surface is not completely covered with a resin layer.

In the substrate, the first region is a region to which the inorganic nanoparticles attach. The first region has a region with a width of 1 µm or less. The region with a width of 1 µm or less is a region that becomes the particle-disposed nanoregion with an array of the inorganic nanoparticles. Thus, the shape, pattern, width and the like of the first region are appropriately set in accordance with the particle-disposed nanoregion. The first region may have a region with a width exceeding 1 µm . The second region is a region excluding the first region and is a region where the inorganic nanoparticles are not disposed.

As the substrate, those exemplified and described as the substrate in the particle-immobilized substrate described above may be used.

The potential difference between the zeta potential of the first region and the zeta potential of the second region is preferably 30 mV or more, more preferably 40 mV or more, still more preferably 50 mV or more, and particularly preferably 60 mV or more. When the potential difference is 30 mV or more, the potential difference between the first region and the second region is sufficiently large, and the inorganic nanoparticles can be easily and selectively disposed in the first region with electrostatic action by appropriately setting the zeta potential of the inorganic nanoparticles. In addition, the inorganic nanoparticles are hardly detached after the attachment. The potential difference of at least one point from pH 2 to 12 (preferably from pH 4 to 10, more preferably from pH 5 to 8) is preferably within the above ranges. When the potential difference is within the above range for at least one point where the pH is within the above range, the inorganic nanoparticles can be attached to the first region with electrostatic action at the pH.

A zeta potential of either the first region or the second region may be positive and a zeta potential of the other may be negative. Alternatively, a zeta potential of both the first region and the second region may be positive, or negative. In particular, it is preferable that a zeta potential of either the first region or the second region is positive and a zeta potential of the other is negative. In this case, the inorganic nanoparticles having a zeta potential with a sign different from the sign of the zeta potential of the first region can be easily disposed in the first region with electrostatic action. In particular, it is more preferable that the zeta potential of the first region is positive, and the zeta potential of the second region is negative.

The potential difference between the zeta potential of the first region and the zeta potential of the inorganic nanoparticles is preferably 30 mV or more, more preferably 40 mV or more, and still more preferably 50 mV or more. When the potential difference is 30 mV or more, the potential difference between the inorganic nanoparticles and the first region is sufficiently large, with which the inorganic nanoparticles can be easily attached to the first region with electrostatic action, and the inorganic nanoparticles are hardly detached after the attachment. The potential difference of at least one point from pH 2 to 12 (preferably from pH 4 to 10, more preferably from pH 5 to 8) is preferably within the above ranges. When the potential difference is within the above range for at least one point where the pH is within the above range, the inorganic nanoparticles can be attached to the first region with electrostatic action at the pH.

The potential difference between the zeta potential of the second region and the zeta potential of the inorganic nanoparticles is preferably less than 30 mV, more preferably 25 mV or less, and still more preferably 20 mV or less. When the potential difference between the zeta potentials is less than 30 mV, the potential difference is small, with which the inorganic nanoparticles and the second region repel each other, and thus the inorganic nanoparticles are less likely to attach to the second region. The zeta potential of at least one point from pH 2 to 12 (preferably from pH 4 to 10, more preferably from pH 5 to 8) is preferably within the above ranges.

Of the first region and the second region, the region having a positive zeta potential preferably has a zeta potential of 5 mV or more, more preferably 10 mV or more. The zeta potential is a value measured under the same conditions as the conditions (for example, pH) for measuring the zeta potential of the inorganic nanoparticles.

The region having a positive zeta potential preferably has a cationic group on the surface, and more preferably, the cationic group is an amino group. One or more cationic groups are preferably present at one bonding position (in one cationic group-containing group) in a region where the zeta potential is positive. The number is more preferably from 2 to 4, and still more preferably 2. The amino group may be any of a primary amino group, a secondary amino group, and a tertiary amino group, but preferably has a primary amino group (in particular, a primary amino group and a secondary amino group). The amino group forms an ammonium ion in the electrostatic attachment step, and the zeta potential of the region becomes positive.

Of the first region and the second region, the region having a negative zeta potential preferably has a zeta potential of -10 mV or less, more preferably -20 mV or less. The region having a negative zeta potential preferably has a hydroxy group or a carboxy group (more preferably, a hydroxy group). The zeta potential is a value measured under the same conditions as the conditions (for example, pH) for measuring the zeta potential of the inorganic nanoparticles.

### Electrostatic Attachment Step

In the electrostatic attachment step, on a substrate including a first region and a second region having different zeta potentials from each other, inorganic nanoparticles are disposed by electrostatic action in the first region of the substrate. Specifically, for example, the substrate is immersed in an aqueous dispersion of the inorganic nanoparticles. At this time, when the potential difference between the zeta potential of the surface of the inorganic nanoparticles and the zeta potential of the first region is large, or when the signs of the zeta potentials are different from each other (that is, when one zeta potential is negative while the other zeta potential is positive), the inorganic nanoparticles attach to the first region with electrostatic action.

The zeta potential of the surfaces of the inorganic nanoparticles may be adjusted by a known or commonly used method. When the inorganic nanoparticles are nanodiamond particles, the zeta potential of the surfaces of the nanodiamond particles may be adjusted by appropriately selecting a compound or a functional group to modify the nanodiamond particles, for example. The preferable ranges of the zeta potential of the inorganic nanoparticles used in the electrostatic attachment step are as described above.

The immersion temperature is, for example, from 0 to 100°C (preferably from 10 to 40°C), and the immersion time is, for example, from 10 seconds to 1 hour (preferably from 20 seconds to 10 minutes). After the immersion, the surface of the substrate may be sufficiently cleaned with pure water, and then water remaining on the surface may be removed by air blowing or the like.

The production method may include another step in addition to the electrostatic attachment step. Examples of the other step include a step of forming two regions A and B having different zeta potentials from each other on the substrate surface (regions AB forming step), which is performed before the electrostatic attachment step. Here, one of the region A and the region B may be set as the first region, and the other may be set as the second region.

### Step (i)

Examples of the regions AB forming step include a step (i) causing a reaction between a reactive functional group present on the substrate and a compound having reactivity with the reactive functional group to form the region A having a zeta potential different from the zeta potential of the substrate surface before the reaction (region A forming stage), and cutting at least some of the groups formed by the reaction in a part of the region A by electron beam irradiation to form the region B having a zeta potential different from the zeta potential of the region A (region B forming stage).

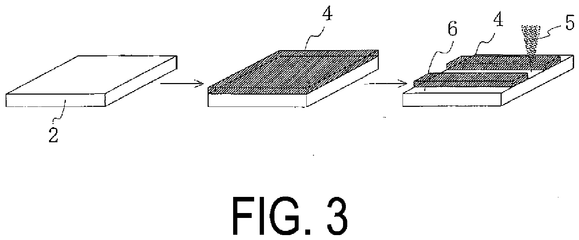

The step (i) will be described in detail with reference to FIG. 3. In the region A forming stage, the region A (4) is formed by applying a compound having reactivity with the reactive functional group present on the substrate 2 onto the substrate 2 and causing the compound to react with the reactive functional group. The application may be performed by using a known or commonly used coater or may be performed by immersing the base material 2 in the compound. The application of the compound may be performed by using a solution or a dispersion with a solvent such as an organic solvent in which the compound can be dissolved or dispersed. In the region A forming stage, the region A (4) may be formed on the entire surface of the substrate 2 or may be formed on a part of the substrate 2.

In the region A forming stage, a Si substrate may be used as the substrate 2, for example, and an amino group-containing silane coupling agent may be used as the compound. A SiO₂ layer is typically present on the surface of the Si substrate. In this case, a hydroxy group (silanol group) on the surface of the SiO₂ layer is caused to react with the amino group-containing silane coupling agent to form a siloxane bond by a condensation reaction, and a group having an amino group is formed on the surface of the Si substrate to form the region A. Examples of the amino group-containing silane coupling agent include 3-aminopropyltriethoxysilane and 3-(2-aminoethylamino)propyltrimethoxysilane.

The condensation reaction is performed, for example, by immersing the base material in a solvent such as an organic solvent in which the silane coupling agent can be dissolved or dispersed, adding the silane coupling agent thereto, and stirring the mixture in an inert gas atmosphere. The temperature in the condensation reaction is, for example, from 10 to 90°C, and the time is, for example, from 3 to 30 hours. The condensation reaction is preferably performed within a range of from pH 2 to 12, more preferably from pH 4 to 10, and still more preferably from pH 5 to 8. After the condensation reaction, the substrate surface may be cleaned as necessary. The cleaning is preferably performed by cleaning with the solvent used in the reaction, followed by cleaning with ethanol and cleaning with pure water. Thereafter, as necessary, water remaining on the substrate surface may be blown off by air blowing or the like, and the substrate may be further dried in a dryer. The region A having an amino group on the surface may be thus formed.

In the region B forming stage, as illustrated in FIG. 3 for example, electron beam irradiation 5 is performed on a part of the region A (4) formed in the region A forming stage to decompose the group formed by the reaction (for example, a group having an amino group) to return the surface of the substrate 2 to the state before the region A (4) is formed, thereby forming the region B (6). That is, the zeta potential of the region B (6) is the same as the zeta potential of the surface of the substrate 2 before the region A (4) is formed.

As illustrated in FIG. 3, the state of the substrate surface may be returned to the state before the region A is formed by electron beam irradiation, or the region B having a zeta potential different from the zeta potential of the region A may be formed by breaking bonds or decomposing at least some of the groups formed by the reaction.

The electron beam irradiation to a part of the region A may be performed in accordance with a pre-designed pattern using an EB lithography apparatus. That is, the shapes of the first region and the second region may be formed in accordance with the pattern shape designed by the EB lithography apparatus.

A substrate including two regions A and B having different zeta potentials from each other on the substrate surface may be thus produced by the step (i).

When the region B formed in the region B forming stage has a region having a width of 1 µm or less, the region B may be used as the first region, and when the region A remaining in the region B forming stage has a region having a width of 1 µm or less, the region A may be used as the first region.

For example, when a Si substrate is used as the substrate 2 and an amino group-containing silane coupling agent is used as the compound, the region A having an amino group on its surface tends to have a positive zeta potential at pH 7 or less. The region B formed by electron beam irradiation has a zeta potential derived from the oxygen-based functional group, and the zeta potential tends to be negative, like the surface of the Si substrate before the region A is formed. Thus, when the region A is used as the first region, inorganic nanoparticles are immobilized in the region A in the electrostatic attachment step by using inorganic nanoparticles having a negative zeta potential. On the other hand, when the region B is used as the first region, inorganic nanoparticles are immobilized in the region B in the electrostatic attachment step by using inorganic nanoparticles having a positive zeta potential.

### Step (ii)

Examples of the region AB forming step also include a step (ii) forming a resist film on the substrate surface and then dissolving a part of the resist film by electron beam irradiation and development to make a hole in the resist film to expose the substrate (resist mask forming stage), causing a reaction between the reactive functional group present on the exposed substrate and a compound having reactivity with the reactive functional group to form the region A having a zeta potential different from the zeta potential of the substrate surface before the reaction (region A forming stage), and removing the resist film on the substrate surface to expose the base material surface and form the region B (resist removing stage).

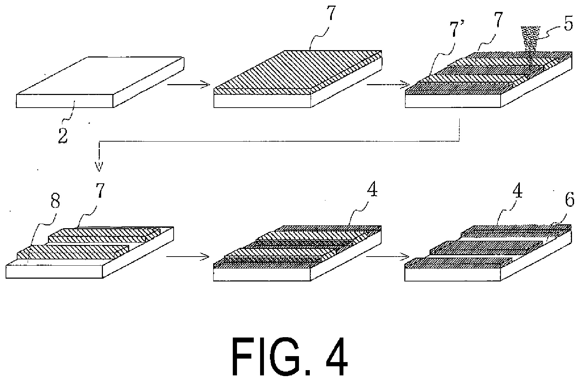

The step (ii) will be described in detail with reference to FIG. 4. In the resist mask forming stage, a resist film 7 is formed on the substrate 2 by a known or commonly used method. Next, electron beam irradiation 5 is performed on a part of the resist film 7, and the resist film of an electron beam irradiation part 7' is dissolved by etching or the like by a subsequent development treatment to expose a substrate surface 8, thereby forming a resist mask. In FIG. 4, instead of the electron beam irradiation part 7', the resist film in a portion where the electron beam is not irradiated may be dissolved by etching or the like to expose the substrate surface 8.

In the region A forming stage, the compound is applied to the exposed substrate surface 8. The compound is preferably applied in a vapor step (vapor deposition) from the viewpoint of preventing dissolution of the resist film 7 during the application. Specifically, the substrate 2 provided with the resist film 7 and a container in an open state into which the compound is put are introduced into an airtight container, and the airtight container is closed and allowed to stand. During the standing, the compound volatilizes in the airtight container and the volatilized compound attaches to the substrate surface 8. The application of the compound may be performed by using a solution or a dispersion with a solvent such as an organic solvent in which the compound can be dissolved or dispersed.

When a Si substrate is used as the substrate 2 and an amino group-containing silane coupling agent is used as the compound, the condensation reaction proceeds in the same manner as in the region A forming step in the step (i), and a group having an amino group is formed on the substrate surface 8 to form the region A (4). In the region A forming stage, the region A (4) may be formed only on the substrate surface 8 or may be formed on the resist film 7 in addition to the substrate surface 8.

Next, in the resist removing stage, the remaining resist film (resist mask) 7 is removed to expose the substrate surface, and the exposed region is formed as the region B (6). The resist mask may be removed by a known or commonly used method, for example, by immersion in an organic solvent (developer) capable of dissolving the resist film.

A substrate including two regions A and B having different zeta potentials from each other on the substrate surface may be thus produced by the step (ii).

When the region of the substrate surface exposed in the resist mask forming step has a region having a width of 1 µm or less, the region A formed thereafter may be used as the first region, and when the region of the resist film remaining in the resist mask forming step has a region having a width of 1 µm or less, the base material surface exposed in the resist removing step (region B) may be used as the first region.

For example, when a Si substrate is used as the substrate 2 and an amino group-containing silane coupling agent is used as the compound, the region A having an amino group on its surface tends to have a positive zeta potential at pH 7 or less. The region B formed by removing the resist mask has a zeta potential derived from the oxygen-based functional group, and the zeta potential tends to be negative, like the surface of the Si substrate before the region A is formed. Thus, when the region A is used as the first region, inorganic nanoparticles are immobilized in the region A in the electrostatic attachment step by using inorganic nanoparticles having a negative zeta potential. On the other hand, when the region B is used as the first region, inorganic nanoparticles are immobilized in the region B in the electrostatic attachment step by using inorganic nanoparticles having a positive zeta potential.

In the above description of the production method, an example has been described in which a Si substrate is used as the substrate, and an amino group-containing silane coupling agent is used as the compound having reactivity with the reactive functional group on the substrate surface. However, the production method is not limited to this example. That is, by using a substrate having a reactive functional group on its surface and a compound having a functional group having reactivity with the reactive functional group and has a zeta potential different from that of the substrate surface in combination, the particle-immobilized substrate may be produced by a known or commonly used technique in the same manner as in the above-described example.

### Method for Producing Diamond-Film-Immobilized Substrate

A substrate on which a diamond film is immobilized (diamond-film-immobilized substrate) may be produced by a CVD step of forming a diamond film on the particle-immobilized substrate using nanodiamond particles as the inorganic nanoparticles by growing the nanodiamond particles on the substrate by a chemical vapor deposition method (CVD method) using the nanodiamond particles as seeds.

The CVD method may be performed by a known or commonly used method. For example, the particle-immobilized substrate is put into a gas phase containing a carbon source such as methane and hydrogen, and plasma of a mixed gas of hydrogen and methane is generated in the gas phase. This generates atomic hydrogen and carbon radicals and causes the nanodiamond particles on the particle-immobilized substrate to grow as seed crystals, and the seed crystals coalesce with each other to form a diamond film.

Various conditions such as temperature, pressure, gas supply amount, and gas concentration in the CVD step are not limited, and they may be appropriately adjusted. The time for performing the CVD step is appropriately adjusted in accordance with the thickness and growth state of the diamond film to be obtained, the width of the pattern (the width of the formation nanoregion to be described later), and the interval. The methane concentration (relative to the total of methane and hydrogen) in the gas phase in which the CVD step is performed is, for example, from 0.1 to 10 vol%, preferably from 1 to 5 vol%. The hydrogen concentration (relative to the total of methane and hydrogen) in the gas phase in which the CVD step is performed is, for example, from 90 to 99.9 vol%, preferably from 95 to 99 vol%. The temperature is preferably from 200 to 1500°C, and more preferably from 500 to 1200°C. The diamond growth time in the CVD step is, for example, from 1 to 30 minutes, preferably from 5 to 25 minutes, more preferably from 10 to 20 minutes.

The diamond film-immobilized substrate obtained by the above production method includes the substrate and a diamond film formed on the substrate. The diamond film is formed by growing nanodiamond particles immobilized as inorganic nanoparticles on the particle-immobilized substrate (grown diamond particles) or by growing and bonding the nanodiamond particles. Examples of the diamond film include a film formed by a plurality of grown diamond particles in which individual diamond particles are grown and are not bonded to adjacent particles, and a film in which individual diamond particles are grown and bonded to adjacent diamond particles. The diamond film may have voids or pores derived from gaps between the nanodiamond particles in the particle-immobilized substrate.

The diamond-film-immobilized substrate preferably has a region (film-formed nanoregion) having a width of 1 µm or less where the diamond film is formed on the substrate. Such a diamond film may be produced by growing nanodiamond particles disposed in the particle-disposed nanoregion. The diamond film may be formed in a region other than the region having a width of 1 µm or less on the substrate.

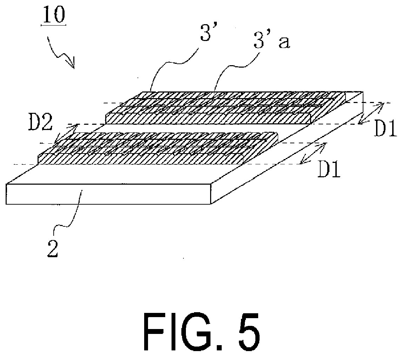

FIG. 5 is an enlarged schematic view of the diamond-film-immobilized substrate having the film-formed nanoregion according to an embodiment of the present disclosure. A diamond-film-immobilized substrate 10 is produced by growing nanodiamond particles 3 on the particle-immobilized substrate 1 illustrated in FIG. 1 by a CVD method. The diamond-film-immobilized substrate 10 illustrated in FIG. 5 includes the substrate 2 and a plurality of diamond films 3'. In the diamond-film-immobilized substrate 10, one diamond film 3' is disposed on the substrate 2 in a region (film-formed nanoregion) having a width D1 of 1 µm or less and extending in a lateral direction (direction orthogonal to the width D 1). A plurality of regions where the width D1 extends in the lateral direction are arranged at intervals of D2 in the longitudinal direction to form a stripe pattern.

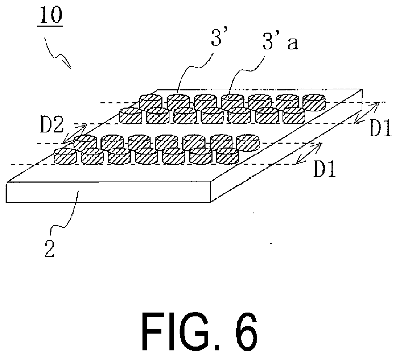

FIG. 6 is an enlarged schematic view of the diamond-film-immobilized substrate having the film-formed nanoregion according to another embodiment of the present disclosure. The diamond-film-immobilized substrate 10 is produced by growing the nanodiamond particles 3 on the particle-immobilized substrate 1 illustrated in FIG. 2 by a CVD method. The diamond-film-immobilized substrate 10 illustrated in FIG. 6 includes the substrate 2 and the diamond films 3'. The diamond film 3' is a film formed by a plurality of grown diamond particles in which the nanodiamond particles 3 in the particle-immobilized substrate illustrated in FIG. 2 are grown to such an extent that the nanodiamond particles 3 are not bonded to each other. In the diamond-film-immobilized substrate 10, the diamond film 3' is disposed on the substrate 2 in a region (film-formed nanoregion) having a width D1 of 1 µm or less and extending in a lateral direction (direction orthogonal to the width D1). A plurality of regions where the width D1 extends in the lateral direction are arranged at intervals of D2 in the longitudinal direction to form a stripe pattern.

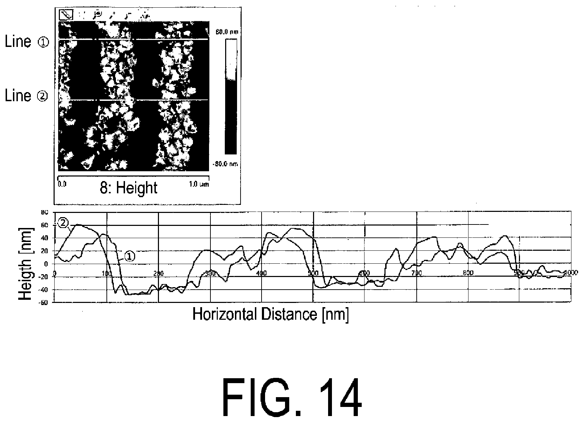

As illustrated in FIGS. 6 and 14 for example, the diamond-film-immobilized substrate may have, on the substrate, a region (substrate-exposed nanoregion) having a width of 1 µm or less where the diamond film is not formed. The substrate-exposed nanoregion may be present in the film-formed nanoregion. Such a diamond-film-immobilized substrate may be produced by growing the nanodiamond particles disposed in the particle-disposed nanoregion until the substrate-exposed nanoregion remains in such a manner that the gaps between the nanodiamond particles are not completely filled. Such a diamond-film-immobilized substrate is produced by growing the nanodiamond particles 3 on the particle-immobilized substrate 1 illustrated in FIG. 2 by a CVD method.

Examples of the shape of the film-formed nanoregion include the shapes illustrated and described as the particle-disposed nanoregion described above. The concept of the "width" in the film-formed nanoregion is the same as that of the "width" in the particle-disposed nanoregion. Only one film-formed nanoregion may be present on the substrate, or a plurality of film-formed nanoregions may be present in the same shape or different shapes. The film-formed nanoregions may be regularly disposed (arranged) or may be irregularly disposed, but it is preferable that they are regularly disposed. Examples of the pattern formed by the regular disposition include a stripe pattern, a dot pattern, a check pattern, a lattice pattern, a houndstooth pattern, and a mesh pattern. The shape of the dots in the dot pattern is not limited to particular shapes, and examples thereof include a cross shape, a circle, and a polygon.

The interval (for example, D2 in FIGS. 5 and 6) between the plurality of particle-disposed regions in the regularly arranged shape such as the stripe pattern or the dot pattern is not limited to particular values, but it is preferably from 0.1 to 1.5 times, more preferably 0.5 to 1.0 times the width.

Since the diamond film is formed by growth of nanodiamond particles, the arithmetic average roughness Ra of the film surface (for example, 3'a in FIGS. 5 and 6) is preferably 6 nm or more (for example, from 6 to 20 nm), more preferably 7 nm or more (for example, from 7 to 15 nm). The root-mean-square height Rq of the diamond film surface (for example, 3'a in FIGS. 5 and 6) is preferably 8 nm or more (for example, from 8 to 30 nm), more preferably 10 nm or more (for example, from 10 to 20 nm). According to a known method, it is possible to leave the diamond film in a region having a width of 1 µm or less on the substrate by polishing and smoothing the surface of the diamond film using a diamond film formation immobilization substrate on which a plate-shaped diamond film is formed, and subsequently removing the diamond film and part of the substrate by etching. However, since such a known method, in which resist mask pattern formation and uniform etching are performed, requires smoothing of the surface of the diamond film, the roughness of the surface of the diamond film after etching is typically low.

The thickness of the diamond film (distance between the substrate surface and the highest point of the diamond film surface) is preferably from 10 to 200 nm, and more preferably from 30 to 100 nm.

Since the diamond-film-immobilized substrate is obtained by growing the nanodiamond particles on the particle-immobilized substrate, the diamond film on the diamond-film-immobilized substrate is formed in a state where the shape of the nanodiamond particles is maintained. Thus, the diamond-film-immobilized substrate may be used for mechanical switching devices, such as MEMS and NEMS, and oscillators. When the diamond film is produced by a CVD method under a high-temperature heating condition, at least a part of the substrate and the diamond film react with each other to form a bond, and thus the diamond film is excellent in adhesion.

### Method for Producing Diamond

Diamond derived from the nanodiamond film may be produced by removing the base material from the diamond-film-immobilized substrate on which the diamond film is immobilized.

The diamond derived from the nanodiamond film is a diamond obtained by peeling off the diamond film from the base material, and is an independent self-standing solid of the diamond film or diamond particles constituting the diamond film. Specifically, when the diamond film is formed of individual grown diamond particles, the resulting diamond is the grown diamond particles. When the diamond film is a single film-like diamond formed by a plurality of diamond particles bonded to each other by growth, the obtained diamond is the film-like diamond. The film-like diamond may have voids or pores derived from the gaps between the nanodiamond particles in the particle-immobilized substrate.

As a method of removing the substrate, a known or commonly used method may be employed, and examples thereof include a method of physically peeling off the substrate from the diamond-film-immobilized substrate and a method of chemically removing the substrate.

According to the method for producing diamond, a diamond film having a geometric shape formed on the diamond-film-immobilized substrate may be obtained as diamond which is an independent self-standing solid such as film-like diamond (rod-shaped diamond). In addition, as the grown diamond particles, a self-standing solid of diamond particles slightly larger than the nanodiamond particles as seed crystals may be obtained independently. When the self-standing solid diamond is in a nanometer scale, it may be dispersed in a solvent to produce a nanodiamond dispersion composition in which diamond is dispersed in a solvent. The nanodiamond dispersion composition may be expected to be used for biological applications such as biosensing and bioimaging.

Each aspect disclosed in the present specification can be combined with any other feature disclosed herein. Note that each of the configurations, combinations thereof, or the like in each of the embodiments are examples, and additions, omissions, replacements, and other changes to the configurations may be made as appropriate without departing from the spirit of the present disclosure. In addition, each aspect of the invention according to the present disclosure is not limited by the embodiments or the following examples but is limited only by the claims.

### Examples

An embodiment of the present invention will be described in further detail below based on examples.

### Example 1

### Pretreatment of Si Substrate

A 500 mL beaker was prepared, 200 mL of deionized water (pure water) was poured in the beaker, 100 mL of ammonia water having a concentration of 12 mass% was added thereto, and the beaker was immersed in an oil bath and heated to about 96°C. Thereafter, the temperature of the oil bath was set to 80°C, and 40 mL of a 30 mass% aqueous hydrogen peroxide solution was charged into the beaker. An RCA (SC-1) cleaning liquid having a temperature of from 75 to 80°C was thus obtained. A commercially available semiconductor Si wafer (4-inch in diameter, Si(100), p-type, one side polished) was cut (cleaved) into a square of 1.5 cm × 1.5 cm with a wafer cutter (diamond scriber) to produce a Si substrate. The Si substrate was quickly put into the cleaning liquid before the decomposition of the hydrogen peroxide solution proceeds, a watch glass was put on the opening of the beaker, the temperature of the oil bath was raised to a temperature of from 75 to 80°C, and the state was maintained for 30 minutes. This cleaning treatment is called SC-1 cleaning of RCA cleaning which is a typical cleaning method for Si substrates, and it has an effect of dissolving and removing organic substances on the surface of the Si substrate and peeling and removing insoluble particles. After 30 minutes, the power supply to the oil bath was turned off, and the cleaning liquid was allowed to cool to 30°C or less. After cooling, without taking out the Si substrate, the Si substrate was sufficiently cleaned by running pure water while being taken care not to contact with air. The polished surface of the substrate after cleaning was dried by air blowing, and the substrate was stored in an airtight container and thus dust in the air does not attach thereto.

### Amino Modification of Si Substrate with Aminosilane Coupling Agent in Liquid Phase Reaction System

Toluene in an amount of 20 mL was placed in a three-necked flask, and the Si substrate subjected to the pretreatment was placed in the toluene solvent. Then, about 0.1 mL of an aminosilane coupling agent (N-(2-aminoethyl)-3-aminopropyltrimethoxysilane) was added to the flask with a syringe. The reaction was performed by heating the flask in an oil bath at 70° C for 12 hours with passing of nitrogen. About 10 mL of toluene was added to the flask after the reaction to clean the Si substrate. Cleaning with toluene was repeated from 2 to 3 times, and then 10 mL of ethanol was added and cleaning was repeated from 2 to 3 times. After cleaning, the Si substrate was taken out and washed with pure water three times repeatedly. The cleaned substrate was subjected to air blow to remove moisture, placed in a petri dish, and subjected to a baking treatment at 110°C in a dryer. The silane coupling treatment was performed in this manner on the entire surface of the Si substrate to form a region where an N-(2-aminoethyl)-3-aminopropylsilyl group was introduced (amino-modified) on the entire surface. The treated substrate was used for the next patterning treatment.

### Patterning of Amino-Modified Si Substrate by Electron Beam Lithography

The surface of the amino-modified Si substrate was irradiated with an electron beam (EB) along a pre-designed pattern using an EB lithography apparatus. Specifically, EB irradiation was performed for the nine types of design patterns indicated in Table 1. Only the amino group in the EB-irradiated region was decomposed to expose the original Si substrate surface, while the amino group remained in the non-EB-irradiated region. As a result, a region having a negative zeta potential (about -40 mV) derived from oxygen-based functional groups on the unmodified Si substrate and a region having a positive zeta potential (about 30 mV) derived from amino groups were able to be patterned at pH 6. The method for measuring the zeta potential is as described below.

**Table 1**

| X | Y | TYPE | SIZE [nm] | Dose time [µm/sec] |
|---|---|---|---|---|
| 1 | 1 | L&S | 2000/2000 (L/S) | 0.06 |
| 1 | 2 | L&S | 1000/500 (L/S) | 0.06 |
| 1 | 3 | L&S | 500/200 (L/S) | 0.06 |
| 2 | 1 | L&S | 200/100 (L/S) | 0.06 |
| 2 | 2 | HOLE (SQ) | 2000/2000 (Λ/Φ) | 20 |
| 2 | 3 | HOLE (SQ) | 1000/500 (Λ/Φ) | 15 |
| 3 | 1 | HOLE (SQ) | 500/200 (Λ/Φ) | 10 |
| 3 | 2 | HOLE (SQ) | 200/100 (Λ/Φ) | 5 |
| 3 | 3 | HOLE (SQ) | 100/50 (Λ/Φ) | 3 |

In the table, "L&S" (Line and Space) represents a stripe shape, L represents the width of the electron beam irradiation region, and S represents the width of the electron beam non-irradiation region. "HOLE(SQ)" represents a shape having a square hole, A represents the width of the electron beam irradiation region, and Φ represents the width of the electron beam non-irradiation region.

### (Selective Application of Nanodiamond (Electrostatic Adsorption))

Nanodiamonds were applied to the Si substrate surfaces by using a ζ-nanodiamond aqueous dispersion (trade name "DINNOVARE", available from DAICEL CORPORATION, zeta potential in pH 6: about -27 mV). Specifically, 10 mL of the aqueous nanodiamond dispersion was collected in a plastic container, and the Si substrate patterned as described above was immersed in the aqueous nanodiamond dispersion. After about 1 minute, the Si substrate was taken out, and the substrate surface was sufficiently washed with pure water. The washed Si substrate surface was subjected to air blow to remove remaining water, and the substrate was stored in an airtight container. The surface morphology of the obtained Si substrate (nanodiamond particle-immobilized substrate) surface was analyzed with an atomic force microscope (AFM) as follows.

### Evaluation of Nanodiamond Attachment State on Si Substrate with AFM

The surface morphology of the nanodiamond particle-immobilized substrate was analyzed by using an AFM apparatus (apparatus name "Dimension Icon", available from Bruker Corporation). The analysis conditions were as follows.
Probe: ScanAsyst-Air
Mode: QNM in Air (standard)
Scan rate: 0.5 Hz

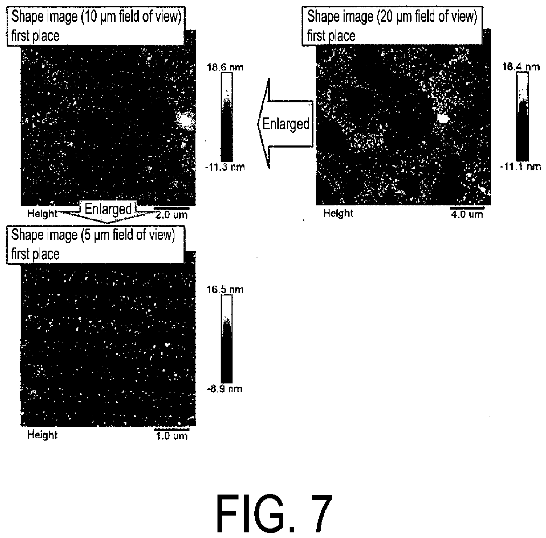

For (X: 1, Y: 1), (X: 1, Y: 2), (X: 1, Y: 3), and (X: 2, Y: 1) of L&S indicated in Table 1, an area where nanodiamond particles were adsorbed and an area where nanodiamond particles were not adsorbed were confirmed. In the patterning of (X: 1, Y: 3), it was confirmed that nanodiamond was adsorbed in an area of 500 nm width and that nanodiamond was not adsorbed in an area of 200 nm width. As a representative example, an AFM image obtained by the patterning of (X: 1, Y: 3) is illustrated in FIG. 7.

### Example 2

### Formation of Resist Pattern by Electron Beam Lithography

A Si substrate pretreated in the same manner as in Example 1 was uniformly applied with resist resin (trade name "ZEP520A", available from Zeon Corporation) with a spin coater. The resist resin formed on the Si substrate was irradiated with EB in accordance with a pre-designed pattern using an EB lithography apparatus. Specifically, EB irradiation was performed for the nine types of design patterns indicated in Table 2. Thereafter, the substrate was immersed in 100 mL of a developer (anisole solvent) for a ZEP520A resist put in a 200 mL beaker to form a pattern of a resist mask according to each design pattern.

**Table 2**

| X | Y | TYPE | SIZE [nm] |
|---|---|---|---|
| 1 | 1 | L&S | 200/200 (L/S) |
| 1 | 2 | L&S | 150/150 (L/S) |
| 1 | 3 | L&S | 100/100 (L/S) |
| 2 | 1 | L&S | 200/200 (L/S) |
| 2 | 2 | L&S | 150/150 (L/S) |
| 2 | 3 | L&S | 100/100 (L/S) |
| 3 | 1 | HOLE (SQ) | 200/200 (Λ/Φ) |
| 3 | 2 | HOLE (SQ) | 150/150 (Λ/Φ) |
| 3 | 3 | HOLE (SQ) | 100/100 (Λ/Φ) |

### Amino Modification of Si Substrate with Aminosilane Coupling Agent in Gas Phase Reaction System

A 400 mL airtight glass container was prepared, and the Si substrate on which the resist mask pattern was formed was placed with the face up. A screw tube containing about 10 mL of 3-aminopropyltriethoxysilane (APTES) was placed on the side of the Si substrate in the airtight glass container in an uncapped state. Thereafter, the lid of the airtight glass container was closed, and the container was left for 20 hours. During the standing, volatilized APTES reacts with the silanol group in the region of the Si substrate where the resist mask is not formed, and the selective region is subjected to amino modification. After standing for 20 hours, the Si substrate was taken out and immersed in toluene for 10 minutes to completely remove the resist mask pattern. As a result, a region having a negative zeta potential (about -40 mV) derived from oxygen-based functional groups on the unmodified Si substrate and a region having a positive zeta potential (about 30 mV) derived from amino groups were able to be patterned at pH 6. The method for measuring the zeta potential is as described below.

### Selective Application of Nanodiamond (Electrostatic Adsorption)

Nanodiamond was applied in the same manner as in Example 1 to the surface of the Si substrate patterned as described above. The surface morphology of the obtained Si substrate (nanodiamond particle-immobilized substrate) surface was analyzed with an atomic force microscope (AFM) as follows. The conditions for AFM analysis were the same as in Example 1.

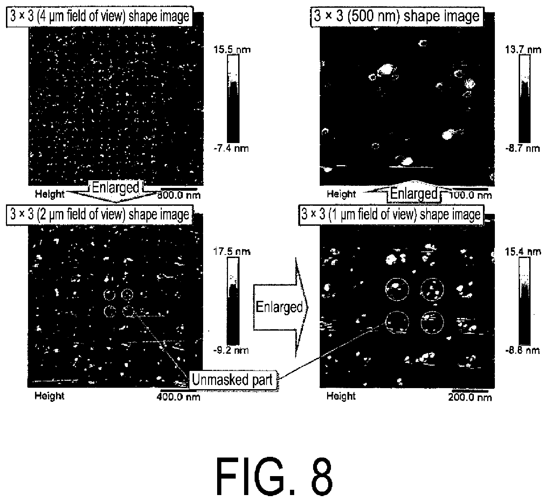

As a result of analysis with the AFM apparatus, an area where nanodiamond particles were adsorbed and an area where nanodiamond particles were not adsorbed were confirmed in all of the nine types of design patterns indicated in Table 2. As a representative example, an AFM image obtained by the patterning of (X: 3, Y: 3), which is the finest pattern, is illustrated in FIG. 8.

### <Method for Measuring Zeta Potential>

"Zetasizer Nano ZS" (trade name, available from Malvern Panalytical) was used for the measurement of the zeta potential. The zeta potential cannot be measured for a substrate-like substance but can be measured only for particles dispersed in a solvent. Thus, the zeta potential of the nanodiamond particles was measured by directly setting the used aqueous dispersion of nanodiamond particles in the apparatus. The zeta potential of the pretreated Si substrate surface was measured by measuring the zeta potential of a dispersion obtained by dispersing silicon nanoparticles in pure water. The zeta potential of the amino-modified Si substrate was measured by measuring the zeta potential of a dispersion obtained by dispersing the silicon nanoparticles subjected to the same amino modification treatment as that of the substrate in pure water. As the principle of the measurement, the speed of electrophoresis of nanoparticles dispersed in the solvent in a certain electric field strength is measured using the laser Doppler effect with a 633 nm laser, and the speed is converted into the zeta potential using the Henry's equation. As the measurement conditions, an average of the results of 300 scans in a backscattering arrangement of 173° is calculated. When the particle concentration in the dispersion is about from 0.01 to 1 mass%, the zeta potential is calculated without depending on the concentration. In this Example, the measurement was performed at a nanodiamond particle concentration of 1 mass% and a silicon nanoparticle concentration of 0.1 mass%.

### Example 3

### Production of Nanodiamond Particle-Immobilized Substrate

A nanodiamond particle-immobilized substrate was produced in the same manner as in Example 2. Four kinds of patterns of "L&S" (200/200 (L/S)), "L&S" (150/150 (L/S)), "L&S" (100/100 (L/S)), and "HOLE(SQ)" (200/200 (Λ/ϕ)) were produced.

### Production of Diamond-Film-immobilized Substrate

The nanodiamond particle-immobilized substrate produce above was subjected to the CVD step to form a diamond film. In the CVD step, a microwave-plasma CVD apparatus (trade name "SDS series: SDS5200S" available from Cornes Technologies Limited) was used. Specifically, the nanodiamond particle-immobilized substrate was placed at the center of a Mo disk in the CVD apparatus, a boron nitride ring was placed around the nanodiamond particle-immobilized substrate, and then the vacuum chamber was evacuated to 3 × 10⁻⁶ Torr or less. H₂ and CH₄ were introduced at a ratio of 97 : 3 and pressurized to 10 Torr, and oscillation of microwaves was started to generate plasma. While the gas flow rate was set to 300 sccm in total of H₂: 291 sccm and CH₄: 9 sccm, the pressure in the apparatus was kept constant by continuously evacuating the gas by a rotary pump. Immediately after the start of transmission of microwaves, the pressure was rapidly set to 60 Torr to shift to CVD conditions suitable for diamond growth. The substrate temperature was measured on the surface of the Si substrate with an optical pyrometer. The diamond growth time was 10 min. The diamond growth conditions are indicated below. After completion of the growth, the gas was evacuated by a rotary pump and a turbo-molecular pump, and after natural cooling for about 30 minutes, the sample was opened to the atmosphere and taken out.

### <Diamond Growth Conditions by Microwave-Plasma CVD>

· Preliminary evacuation pressure: 1.0 × 10 ⁻⁶ Torr or less
· CH₄ concentration {CH₄/(CH₄ + H₂)}: 3 vol%
· Discharge gas pressure: 60 Torr
· Gas flow rate: 300 sccm
· Microwave power: 1.2 kW
· Substrate temperature: about 1030°C
· Growth time: 10 min

The surfaces of the obtained Si substrates (diamond-film-immobilized substrates) were analyzed with a scanning electron microscope (SEM) (model number "SU5000", available from Hitachi High-Tech Corporation). The acceleration voltage was 3.0 kV.

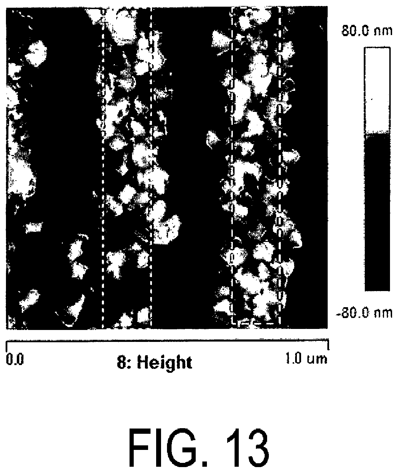

For the substrates subjected to the SEM analysis, the types of patterns and the drawing numbers of these SEM images are indicated in Table 3. The patterns indicated in Table 3 are design patterns of the nanodiamond particle-immobilized substrate before the CVD step is performed. As a result of analysis with the SEM apparatus, an area where a diamond film formed by growth of nanodiamond particles was present and an area where the diamond film was not present were confirmed in all of the four types of design patterns indicated in Table 3. As a result of measuring the surface roughness of the diamond film of No. 1 at 2 points with the atomic force microscope (AFM), the arithmetic mean roughness Ra was 8.70 nm and 11.2 nm, and the root-mean-square height Rq was 11.1 nm and 14.4 nm (measurement points are indicated in FIG. 13). Further, a sectional plot of the height of the diamond film was measured for No. 1. The measurement points and the measurement results are indicated in FIG. 14.

**[Table 3]**

| No. | Pattern | SEM image |
|---|---|---|
| 1 | L/S 200/200 (L/S) | FIG. 9 |
| 2 | L/S 150/150 (L/S) | FIG. 10 |
| 3 | L/S 100/100 (L/S) | FIG. 11 |
| 4 | HOLE(SQ) 200/200 (Λ/Φ) | FIG. 12 |

Hereinafter, variations of the invention according to the present disclosure will be described.
[Appendix 1] A particle-immobilized substrate including a substrate and a plurality of inorganic nanoparticles disposed on the substrate, the plurality of inorganic nanoparticles being disposed in contact with each other in a region having a width of 1 µm or less on the substrate.
[Appendix 2] The particle-immobilized substrate according to Appendix 1, in which a potential difference between a zeta potential of the inorganic nanoparticles and a zeta potential of a surface of the substrate at a position where the inorganic nanoparticles are disposed is 30 mV or more (or 40 mV or more, 50 mV or more).
[Appendix 3] The particle-immobilized substrate according to Appendix 1 or 2, in which a zeta potential of either the inorganic nanoparticles or a surface of the substrate at a position where the inorganic nanoparticles are disposed is positive and a zeta potential of the other is negative.
[Appendix 4] A particle-immobilized substrate including a substrate and inorganic nanoparticles disposed on the substrate, in which a potential difference between a zeta potential of the inorganic nanoparticles and a zeta potential of a surface of the substrate at a position where the inorganic nanoparticles are disposed is 30 mV or more (or 40 mV or more, 50 mV or more).
[Appendix 5] The particle-immobilized substrate according to Appendix 4, wherein a zeta potential of either the inorganic nanoparticles or the surface of the substrate at the position where the inorganic nanoparticles are disposed is positive, and a zeta potential of the other is negative.
[Appendix 6] A particle-immobilized substrate including a substrate and inorganic nanoparticles disposed on the substrate, in which a zeta potential of either the inorganic nanoparticles or a surface of the substrate at a position where the inorganic nanoparticles are disposed is positive and a zeta potential of the other is negative.
[Appendix 7] The particle-immobilized substrate according to any one of Appendices 1 to 6, in which a plurality of the regions having a width of 1 µm or less (or 600 nm or less, 300 nm or less, 150 nm or less) is regularly arranged on the substrate, and the inorganic nanoparticles are disposed in each of the plurality of the regions having a width of 1 µm or less (or 600 nm or less, 300 nm or less, 150 nm or less).
[Appendix 8] The particle-immobilized substrate according to any one of Appendices 1 to 7, in which the nanoparticles include one or more selected from the group consisting of metal nanoparticles, semiconductor nanoparticles, and nanocarbon particles (preferably nanocarbon particles, more preferably nanodiamond particles).
[Appendix 9] The particle-immobilized substrate according to any one of Appendices 1 to 8, in which the inorganic nanoparticles and a surface of a region of the substrate where the inorganic nanoparticles are disposed have zeta potentials of different sign.
[Appendix 10] The particle-immobilized substrate according to any one of Appendices 1 to 9, in which the inorganic nanoparticles and a surface of a region of the substrate where the inorganic nanoparticles are not disposed have zeta potentials of the same sign.
[Appendix 11] The particle-immobilized substrate according to any one of Appendices 1 to 10, in which a zeta potential of the inorganic nanoparticles is negative (preferably, the zeta potential is -5 mV or less, -10 mV or less, or -15 mV or less).
[Appendix 12] The particle-immobilized substrate according to Appendix 11, in which a zeta potential of a region of the substrate where the inorganic nanoparticles are disposed is positive (preferably 5 mV or more, more preferably 10 mV or more).
[Appendix 13] The particle-immobilized substrate according to Appendix 11 or 12, in which a zeta potential of a region of the substrate where the inorganic nanoparticles are not disposed is negative (preferably -10 mV or less, more preferably -20 mV or less).
[Appendix 14] The particle-immobilized substrate according to any one of Appendices 1 to 10, in which a zeta potential of the inorganic nanoparticles is positive (preferably a zeta potential of 5 mV or more, 10 mV or more, or 20 mV or more).
[Appendix 15] The particle-immobilized substrate according to Appendix 14, in which a zeta potential of a region of the substrate where the inorganic nanoparticles are disposed is negative (preferably -10 mV or less, more preferably -20 mV or less).
[Appendix 16] The particle-immobilized substrate according to Appendix 14 or 15, in which a zeta potential of a region of the substrate where the inorganic nanoparticles are not disposed is positive (preferably 5 mV or more, more preferably 10 mV or more).
[Appendix 17] The particle-immobilized substrate according to any one of Appendices 1 to 16, in which a potential difference between a zeta potential of the inorganic nanoparticles and a zeta potential of a surface of a region of the substrate where the inorganic nanoparticles are disposed is 30 mV or more (or 40 mV or more, 50 mV or more, 60 mV or more).
[Appendix 18] The particle-immobilized substrate according to any one of Appendices 1 to 17, in which a potential difference between a zeta potential of a region of the substrate where the inorganic nanoparticles are disposed and a zeta potential of a region where the inorganic nanoparticles are not disposed is 30 mV or more (or 40 mV or more, 50 mV or more, 60 mV or more).
[Appendix 19] The particle-immobilized substrate according to any one of Appendices 1 to 18, in which a potential difference between a zeta potential of the inorganic nanoparticles and a zeta potential of a surface of a region of the substrate where the inorganic nanoparticles are not disposed is less than 30 mV (or 25 mV or less, 20 mV or less).
[Appendix 20] The particle-immobilized substrate according to any one of Appendices 1 to 19, in which the substrate includes a hydroxy group or a carboxy group (preferably a hydroxy group) on a surface of a region where the inorganic nanoparticles are not disposed.
[Appendix 21] The particle-immobilized substrate according to any one of Appendices 1 to 20, in which the inorganic nanoparticles are particles having an inorganic substance constituting the inorganic nanoparticles being exposed on a surface of the particles.
[Appendix 22] A method for producing a particle-immobilized substrate, the method including disposing, on a substrate including a first region and a second region with a potential difference of each other between a zeta potential of the first region and a zeta potential of the second region of 30 mV or more (or 40 mV or more, 50 mV or more), inorganic nanoparticles by electrostatic action in a region of 1 µm or less (or 600 nm or less, 300 nm or less, 150 nm or less) that is present in the first region.
[Appendix 23] The method for producing a particle-immobilized substrate according to Appendix 22, in which a zeta potential of either the first region or the second region is positive and a zeta potential of the other is negative.
[Appendix 24] A method for producing a particle-immobilized substrate including disposing, on a substrate including a first region and a second region in which a zeta potential of either the first region or the second region is positive and a zeta potential of the other is negative, inorganic nanoparticles by electrostatic action in a region having a width of 1 µm or less that is present in the first region.
[Appendix 25] The method for producing a particle-immobilized substrate according to any one of Appendices 22 to 24, in which a plurality of the first regions is regularly arranged on the substrate, and the inorganic nanoparticles are disposed in each of the plurality of the first regions.
[Appendix 26] The method for producing a particle-immobilized substrate according to any one of Appendices 22 to 25, in which the nanoparticles include one or more selected from the group consisting of metal nanoparticles, semiconductor nanoparticles, and nanocarbon particles (preferably nanocarbon particles, more preferably nanodiamond particles).
[Appendix 27] The method for producing a particle-immobilized substrate according to any one of Appendices 22 to 26, in which the inorganic nanoparticles and a surface of the second region have zeta potentials of the same sign.
[Appendix 28] The method for producing a particle-immobilized substrate according to any one of Appendices 22 to 27, in which a zeta potential of the inorganic nanoparticles is negative (preferably a zeta potential of -5 mV or less, -10 mV or less, or -15 mV or less).
[Appendix 29] The method for producing a particle-immobilized substrate according to Appendix 28, in which a zeta potential of a surface of the first region of the substrate is positive (preferably 5 mV or more, more preferably 10 mV or more).
[Appendix 30] The method for producing a particle-immobilized substrate according to Appendix 28 or 29, in which a zeta potential of a surface of the second region of the substrate is negative (preferably -10 mV or less, more preferably -20 mV or less).
[Appendix 31] The method for producing a particle-immobilized substrate according to any one of Appendices 22 to 27, in which a zeta potential of the inorganic nanoparticles is positive (preferably a zeta potential of 5 mV or more, 10 mV or more, or 20 mV or more).
[Appendix 32] The method for producing a particle-immobilized substrate according to Appendix 31, in which a zeta potential of a surface of the first region of the substrate is negative (preferably -10 mV or less, more preferably -20 mV or less).
[Appendix 33] The method for producing a particle-immobilized substrate according to Appendix 31 or 32, in which a zeta potential of a surface of the second region of the substrate is positive (preferably 5 mV or more, more preferably 10 mV or more).
[Appendix 34] The method for producing a particle-immobilized substrate according to any one of Appendices 22 to 33, in which a potential difference between a zeta potential of the inorganic nanoparticles and a zeta potential of the surface of the first region is 30 mV or more (or 40 mV or more, 50 mV or more).
[Appendix 35] The method for producing a particle-immobilized substrate according to any one of Appendices 22 to 34, in which a potential difference in zeta potential between the inorganic nanoparticles and the surface of the second region is less than 30 mV (or 25 mV or less, 20 mV or less).
[Appendix 36] The method for producing a particle-immobilized substrate according to any one of Appendices 22 to 35, in which a region of the first region and the second region having a negative data potential on a surface includes a hydroxy group or a carboxy group (preferably a hydroxy group) on the surface.
[Appendix 37] The method for producing a particle-immobilized substrate according to any one of Appendices 22 to 36, in which a region of the first region and the second region having a positive data potential on a surface includes a cationic group (preferably an amino group) on the surface.
[Appendix 38] The method for producing a particle-immobilized substrate according to Appendix 37, in which at least one (preferably from 2 to 4, more preferably 2) cationic group is present at one bonding position in a region having a positive zeta potential.
[Appendix 39] The method for producing a particle-immobilized substrate according to Appendix 37 or 38, in which the cationic group has a primary amino group (preferably a primary amino group and a secondary amino group).
[Appendix 40] The method for producing a particle-immobilized substrate according to any one of Appendices 22 to 39, in which the inorganic nanoparticles are particles having an inorganic substance constituting the inorganic nanoparticles being exposed on a surface of the particles.
[Appendix 41] The method for producing a particle-immobilized substrate according to any one of Appendices 22 to 40, further including a regions AB forming step, which is performed prior to the electrostatic attachment step, of forming two regions A and B having different zeta potentials with each other on a surface of the substrate, in which one of either the region A or the region B is the first region, and the other is the second region.
[Appendix 42] The method for producing a particle-immobilized substrate according to Appendix 41, in which the regions AB forming step includes a region A forming stage of causing a reaction between a reactive functional group present on the substrate and a compound having reactivity with a reactive functional group to form the region A having a zeta potential different from the zeta potential of the substrate surface before the reaction, and region B forming stage of cutting at least some of the groups formed by the reaction in a part of the region A by electron beam irradiation to form the region B having a zeta potential different from the zeta potential of the region A.
[Appendix 43] The method for producing a particle-immobilized substrate according to Appendix 42, in which a Si substrate is used as the substrate, and an amino group-containing silane coupling agent is used as the compound.
[Appendix 44] The method for producing a particle-immobilized substrate according to Appendix 41, in which the regions AB forming step includes a resist mask forming stage of forming a resist film on a surface of the substrate and then dissolving a part of the resist film by electron beam irradiation and development to make a hole in the resist film to expose the substrate, a region A forming stage of causing a reaction between the reactive functional group present on the exposed substrate and a compound having reactivity with the reactive functional group to form the region A having a zeta potential different from the zeta potential of the surface of the substrate before the reaction, and a resist removing stage of removing the resist film on the substrate surface to expose the base material surface and form the region B.
[Appendix 45] A method for producing a diamond-film-immobilized substrate including a CVD step of forming a diamond film on the particle-immobilized substrate according to any one of Appendices 1 to 21 by growing the nanodiamond particles on the substrate by a chemical vapor deposition (CVD) method using the nanodiamond particles as seeds.
[Appendix 46] The method for producing a diamond film-immobilized substrate according to Appendix 45, in which in the CVD step, the diamond film is formed in a region having a width of 1 µm or less on the substrate.
[Appendix 47] The method for producing a diamond-film-immobilized substrate according to Appendix 45 or 46, in which a region having a width of 1 µm or less where the diamond film is not formed is formed on the substrate by the CVD step.
[Appendix 48] A diamond-film-immobilized substrate including a substrate and a diamond film formed on the substrate, in which the diamond film is formed in a region having a width of 1 µm or less on the substrate, and a surface of the diamond film has an arithmetic mean roughness Ra of 6 nm or more (7 nm or more, from 6 to 20 nm, or from 7 to 15 nm).
[Appendix 49] The diamond-film-immobilized substrate according to Appendix 48, in which the surface of the diamond film has a root-mean-square height Rq of 8 nm or more (10 nm or more, from 8 to 30 nm, or from 10 to 20 nm).
[Appendix 50] A diamond-film-immobilized substrate including a substrate and a diamond film formed on the substrate, in which the diamond film is formed in a region having a width of 1 µm or less on the substrate, and a surface of the diamond film has a root-mean-square height Rq of 8 nm or more (10 nm or more, from 8 to 30 nm, or from 10 to 20 nm).
[Appendix 51] The diamond-film-immobilized substrate according to any one of Appendices 48 to 50, further including a region having a width of 1 µm or less where the diamond film is not formed on the substrate.
[Appendix 52] The diamond-film-immobilized substrate according to Appendix 50, in which the region having a width of 1 µm or less where the diamond film is not formed on the substrate is included in the region having a width of 1 µm or less where the diamond film is formed on the substrate.
[Appendix 53] A method for producing diamond including removing the substrate from the diamond-film-immobilized substrate according to any one of Appendices 45 to 52 to obtain diamond derived from the diamond film.
[Appendix 54] The method for producing diamond according to Appendix 53, in which the diamond derived from the diamond film is the diamond film or diamond particles constituting the diamond film.

### Reference Signs List

- 1: Resin-immobilized substrate
- 2: Substrate
- 3: Inorganic nanoparticle
- 4: Region A
- 5: Electron beam irradiation
- 6: Region B
- 7: Resist film
- 7': Electron beam irradiation part
- 8: Base material surface
- 10: Diamond-film-immobilized substrate
- 3': Diamond film
- 3'a: Diamond film surface
- D1: Width of particle-disposed region
- D2: Interval between particle-disposed regions

## Claims

1. A particle-immobilized substrate comprising a substrate and a plurality of inorganic nanoparticles disposed on the substrate, the plurality of inorganic nanoparticles being disposed in contact with each other in a region having a width of 1 µm or less on the substrate.

2. A particle-immobilized substrate comprising a substrate and inorganic nanoparticles disposed on the substrate,
wherein a potential difference between a zeta potential of the inorganic nanoparticles and a zeta potential of a surface of the substrate at a position where the inorganic nanoparticles are disposed is 30 mV or more.

3. The particle-immobilized substrate according to claim 1 or 2, wherein a plurality of the regions having a width of 1 µm or less is regularly arranged on the substrate, and the inorganic nanoparticles are disposed in each of the plurality of the regions having a width of 1 µm or less.

4. The particle-immobilized substrate according to any one of claims 1 to 3, wherein the nanoparticles include nanodiamond particles.

5. A method for producing a particle-immobilized substrate, the method comprising disposing, on a substrate including a first region and a second region with a potential difference of each other between a zeta potential of the first region and a zeta potential of the second region of 30 mV or more, inorganic nanoparticles by electrostatic action in a region having a width of 1 µm or less that is present in the first region.

6. The method for producing a particle-immobilized substrate according to claim 5, wherein a zeta potential of either the first region or the second region is positive, and a zeta potential of the other is negative.

7. A method for producing a particle-immobilized substrate, the method comprising disposing, on a substrate including a first region and a second region in which a zeta potential of either the first region or the second region is positive and a zeta potential of the other is negative, inorganic nanoparticles by electrostatic action in a region having a width of 1 µm or less that is present in the first region.

8. The method for producing a particle-immobilized substrate according to any one of claims 5 to 7, wherein a plurality of the first regions is regularly arranged on the substrate, and the inorganic nanoparticles are disposed in each of the plurality of the first regions.

9. The method for producing a particle-immobilized substrate according to any one of claims 5 to 8, wherein the inorganic nanoparticles include nanodiamond particles.

10. A method for producing a diamond-film-immobilized substrate, the method comprising a CVD step of forming a diamond film on the particle-immobilized substrate described in claim 4 by growing the nanodiamond particles on the substrate by a chemical vapor deposition (CVD) method using the nanodiamond particles as seeds.

11. The method for producing a diamond-film-immobilized substrate according to claim 10, wherein, in the CVD step, the diamond film is formed in a region having a width of 1 µm or less on the substrate.

12. A method for producing diamond, the method comprising removing the substrate from the diamond-film-immobilized substrate described in claim 10 or 11 to obtain an independent self-standing solid of the diamond film or diamond particles constituting the diamond film.
